# FASCICULE DE BREVET EUROPEEN

(11) **EP 0 467 360 B1**
(45) Date de publication et mention de la délivrance du brevet: **31.08.1994**
(21) Numéro de dépôt: 91112023.6
(22) Date de dépôt: 18.07.1991
(51) Int. Cl.: C04B 37/02, H01L 39/24

(54) **Procédé de realisation d'une liaison à hautes performances entre un métal et une pièce massive en céramique supraconductrice**
Verfahren zur Herstellung einer Hochleistungsverbindung zwischen einem Metall und einem massiven Teil aus supraleitendem keramischem Material
Method for producing a high performance joint between a metal and a superconducting ceramic article

(30) Priorité: 20.07.1990 FR 9009313
(43) Date de publication de la demande: 22.01.1992
(73) Titulaire: GEC ALSTHOM SA, 75116 Paris (FR)
(72) Inventeur: Duperray, Gérard, F-91290 La Norville (FR); Lempereur, Simon, F-94800 Villejuif (FR)
(74) Mandataire: Weinmiller, Jürgen

(56) Documents cités:
- EP-A- 0 292 126
- EP-A- 0 368 791
- EP-A- 0 426 077
- US-A- 3 057 445
- IEEE TRANSACTIONS ON MAGNETICS, vol. 25, no. 2, mars 1989, pages 2056-2059, New York, US; J. MORELAND et al.: "Ag screen contacts to sintered YBa2Cu3Ox powder for rapid semiconductor characterization"
- APPLIED PHYSICS LETTERS, vol. 54, no. 25, 19 juin 1989, pages 2605-2607, New York, US; S. JIN et al.: "Low-resistivity contacts to bulk high Tc superconductors"
- WORLD PATENT INDEX LATEST, semaine 8544, accession no. 85-273723 (44) Derwent Publications Ltd, Londres, GB; & JP-A-60 186 483 (SHINMEIWA IND. K.K.) 21-09-1985

## Description

La présente invention concerne un procédé de réalisation d'une liaison à hautes performances entre un métal et une pièce massive en céramique supraconductrice.

Le problème est de réaliser une liaison de faible résistance électrique entre un métal et une céramique supraconductrice, afin d'acheminer de forts courants à la température d'utilisation, sans perturber son état de résistance nulle. Ainsi, une telle liaison doit posséder une résistance surfacique inférieure à 10⁻¹⁰ Ω.m² pour une densité de courant la traversant de l'ordre de 10³ A/cm², ce qui est le cas d'une application aux descentes de courant.

Actuellement les contacts électriques performants, qui présentent une résistance de l'ordre de 10⁻¹⁰ Ω.m², et qui sont mis en oeuvre sur une céramique de type YBa₂Cu₃O_{7-δ}, sont réalisés en déposant une couche d'argent par pulvérisation cathodique sur des petites surfaces. Mais un tel dépôt d'argent ne présente pas assez d'adhérence pour permettre un raccordement solide et performant de la céramique avec un métal normal.

On connaît également, par l'article paru dans Appl. Phys. Lett. 54(25), 19 juin 1989, page 2605 "Low-resistivity contacts to bulk high Tc superconductors" un procédé consistant à disposer dans un moule de la poudre de céramique, à introduire des fils d'argent de diamètre 0,125 mm orthogonalement à la couche de poudre, à recouvrir de poudre de céramique en laissant dépasser les fils, à comprimer et à cuire. On constate qu'un tel procédé est délicat à mettre en oeuvre car les fils d'argent ne doivent pas être détériorés au moment de la compression. Par ailleurs les fils ne peuvent laisser passer que des courants faibles, de l'ordre de 5 ampères.

L'article précité propose également un autre procédé consistant à mettre dans un moule un mélange homogène de poudre de céramique et de poudre d'argent, à comprimer et à cuire à une température de 1030°C, dépassant la température du point de fusion de l'argent. Il se crée alors des bulles, des particules d'argent se dispersent, apparaissent à la surface de la pièce et définissent ainsi des contacts électriques. Le procédé rend très difficile la maîtrise de la géométrie de ces contacts.

Dans le brevet français n° 89 14432 on décrit un procédé selon lequel, dans le moule où est introduite la poudre de céramique, on juxtapose à cette poudre, sans le mélanger avec elle, un volume de poudre d'argent correspondant à la forme de la liaison souhaitée et situé à l'endroit voulu. On comprime l'ensemble et on fritte à une température inférieure à la température de fusion de l'argent.

On constate que ce procédé peut présenter certains défauts lorsqu'on l'applique à des pièces de grandes dimensions, par exemple à des tubes de diamètre extérieur supérieur à 20mm, d'épaisseur supérieure à 2 mm et de longueur supérieure à 120mm.

Ainsi le démoulage d'une telle pièce peut s'accompagner de fissures ou de casse au niveau de l'interface céramique-argent ; par ailleurs la liaison présente une certaine fragilité aux chocs thermiques lorsqu'on la soude à une connexion reliant le dispositif supraconducteur à son environnement électrique, ou lorsqu'elle est soumise aux cycles thermiques : descente en froid - remontée à la température ambiante.

La présente invention a pour but de mettre en oeuvre un procédé permettant d'obtenir des pièces supraconductrices de grandes dimensions avec une liaison métallique sans fissure, présentant une excellente tenue aux chocs thermiques et une résistance de contact restant pratiquement constante dans tout le domaine d'utilisation du matériau supraconducteur.

La présente invention a pour objet un procédé de réalisation d'une liaison à hautes performances entre un métal et une pièce massive en céramique supraconductrice, ladite pièce étant fabriquée à partir de granulés, ou de poudre, de ladite céramique ou de ses précurseurs que l'on introduit dans un moule, procédé selon lequel, dans ledit moule, on juxtapose auxdits granulés, ou à ladite poudre, de céramique au moins un volume de poudre d'argent ou d'or correspondant à la forme de ladite liaison et situé à l'endroit voulu, on comprime et on fritte la céramique, caractérisé par le fait que l'on intègre dans ledit moule, au niveau de ladite liaison, un corps en argent, or ou cuivre, à porosité ouverte, du genre mousse, paille, ou treillis, susceptible de contenir dans ses pores d'une part ledit volume de poudre d'argent ou d'or, et d'autre part une fraction desdits granulés, ou de ladite poudre, de céramique.

On entend par granulés un produit intermédiaire constitué de poudre agglomérée sous forme de grains sphériques de dimensions comprises entre 50 µm et 350 µm, qui présentent une meilleure coulabilité que la poudre.

Ladite mousse métallique peut être constituée d'alvéoles grossièrement dodécaédriques communiquant par leurs faces pentagonales, le métal ne subsistant que sur les arêtes.

On appelle paille métallique un ensemble constitué de fibres métalliques enchevêtrées.

On peut mettre en oeuvre également des toiles métalliques avec une ouverture de maille suffisante, à condition d'en empiler plusieurs épaisseurs.

Toutes ces structures ont une porosité supérieure à 85%. Le diamètre de leurs pores doit être adapté à celui des granulés qui est lui-même compris entre 200 µm et 1 mm. Elles présentent une bonne conductivité et le courant chemine à travers des brins conducteurs.

Selon une variante de mise en oeuvre, de la poudre d'argent pelliculaire est intégrée dans lesdits granulés, dans une proportion inférieure à 15% en poids. On appelle poudre d'argent pelliculaire de la poudre dont les grains sont des disques de diamètre compris entre 10 µm et 40 µm et d'épaisseur comprise entre 0,1 µm et 0,5 µm.

On peut réaliser grâce au procédé selon l'invention des pièces de grandes dimensions sans fissure ni casse au niveau de la liaison avec le métal qui est solidement accroché à la céramique grâce aux brins métalliques qui y sont insérés. Ce métal constitue un embout directement soudable. Par ailleurs sa structure lui permet d'absorber les contraintes thermiques dues aux différences de dilatation entre le métal et la céramique, même si les cycles thermiques sont répétés.

Il est remarquable que les propriétés supraconductrices de la pièce obtenue par le procédé selon l'invention ne soient pas dégradées alors qu'une dégradation importante apparaît en cas de mélange de la poudre supraconductrice avec de la poudre métallique. La résistance de contact reste pratiquement constante dans tout le domaine d'utilisation du matériau supraconducteur, c'est-à-dire jusqu'au point de transition correspondant au courant de transport critique.

D'autres caractéristiques et avantages de la présente invention apparaîtront au cours de la description suivante de modes de réalisation donnés à titre illustratif mais nullement limitatif. Dans le dessin annexé :
- La figure 1 illustre schématiquement un premier exemple de mise en oeuvre du procédé selon l'invention.
- La figure 2 montre schématiquement en perspective agrandie une mousse métallique mise en oeuvre dans le procédé de la figure 1.
- La figure 3 montre schématiquement un tube obtenu par la mise en oeuvre du procédé selon la figure 1.
- La figure 4 illustre les variations des résistivités des liaisons métalliques du tube de la figure 3 en fonction de la densité de courant.
- La figure 5 est une vue très schématique d'un second exemple de mise en oeuvre du procédé selon l'invention appliqué à un cylindre plein.
- La figure 6 est une vue très schématique d'un troisième exemple de mise en oeuvre du procédé selon l'invention appliqué à une pièce parallélépipédique.

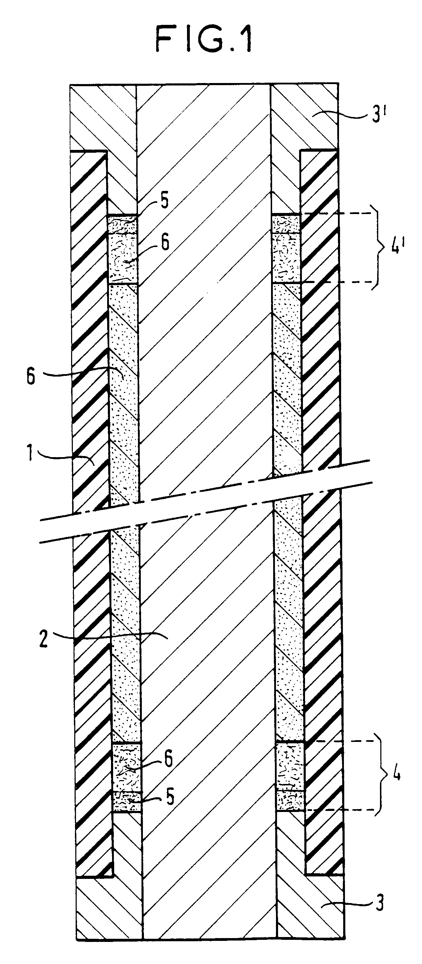

### EXEMPLE 1 (voir figure 1)

On réalise de la manière suivante un tube en céramique Y₁Ba₂Cu₃O₇ de diamètre extérieur 20mm, de diamètre intérieur 15mm et de longueur 120mm, avec des liaisons métalliques au niveau de ses deux bases.

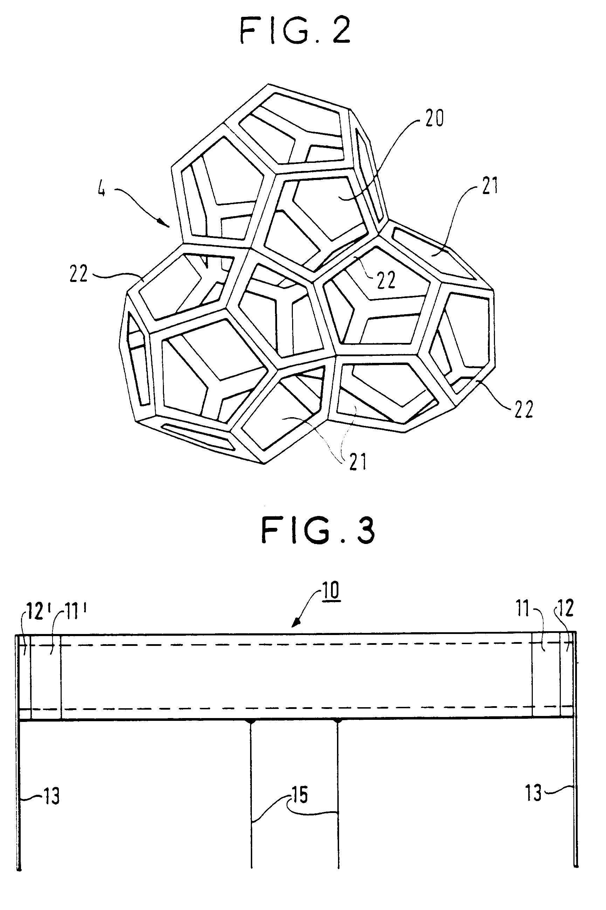

On utilise un moule 1 à paroi déformable, pour compression isostatique, avec une broche métallique centrale 2 et un bouchon inférieur 3. L'ensemble est posé sur une table vibrante non illustrée. On introduit successivement dans l'espace annulaire ménagé entre le moule 1 et la broche 2 :
- un anneau 4 de mousse d'argent qui sera décrit plus en détail à l'aide de la figure 2 ; le diamètre des pores de la mousse est de l'ordre de 500 µm,
- 3g de poudre d'argent 5 de diamètre de l'ordre de 100 µm qui traverse les pores de l'anneau 4 et tombe au fond du moule,
- 100g de granulés 6 de précurseurs pour la synthèse de Y₁Ba₂Cu₃O₇ ; ces granulés ayant un diamètre moyen de 200 µm, une fraction d'entre eux s'infiltre dans l'anneau 4,
- un anneau 4' de mousse d'argent identique à l'anneau 4,
- 3g de poudre d'argent 5.

En se reportant à la figure 2, on voit que la mousse d'argent 4 est très schématiquement constituée d'alvéoles 20 grossièrement dodécaédriques, communiquant par leurs faces 21 pentagonales, l'argent ne subsistant qu'au niveau des arêtes 22.

Lorsque le remplissage est terminé, on obture le moule 1 à l'aide du bouchon 3' et on comprime à 200 Mégapascals.

On démoule le tube et on lui applique le traitement thermique habituel pour synthétiser la phase supraconductrice et la fritter. A titre d'exemple, ce traitement comporte un palier de 10 à 20 heures entre 880°C et 910°C puis une descente lente entre 600°C et 250°C, pour réoxygéner le matériau sous forme orthorombique ; le traitement est effectué de préférence sous une atmosphère comportant 20% à 100% d'oxygène.

On obtient un tube 10 visible dans la figure 3 ; ses liaisons métalliques comprennent d'une part les zones 11 et 11' où la mousse 4 est noyée dans le matériau supraconducteur et d'autre part des embouts 12 et 12' en argent massif résultant d'une combinaison entre la mousse 4 - 4' et la poudre d'argent 5.

On soude à l'étain deux clinquants 13 et 13' respectivement sur les embouts 12 et 12' pour amener le courant. Après refroidissement dans l'azote liquide à 77K, on mesure la résistance des liaisons métalliques selon l'invention, en fonction de la densité de courant.

La résistivité de contact ρₛ est définie par ρₛ = RS R étant la résistance de contact et S sa surface.

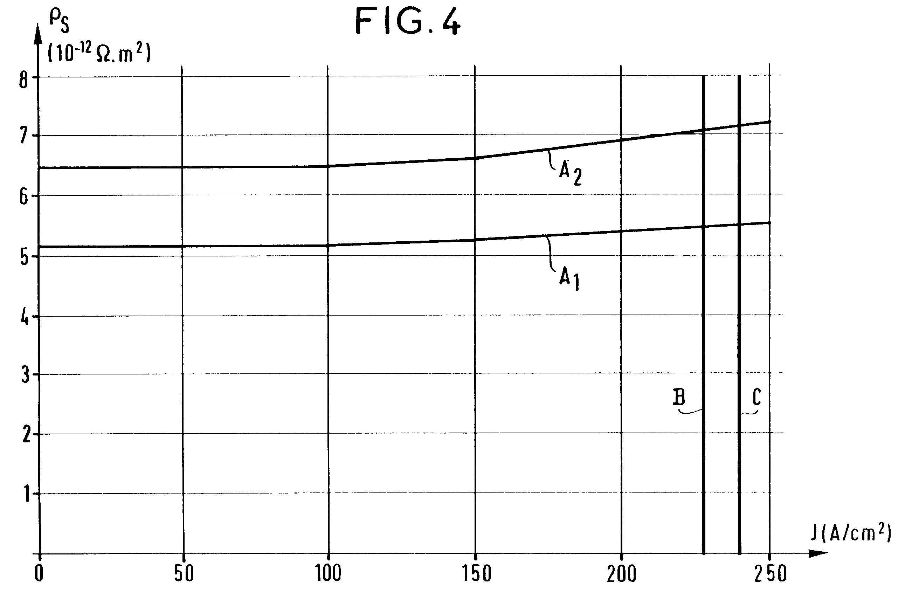

On a reporté dans la figure 4 les variations de ρₛ (10⁻¹² Ω.m²) en fonction de la densité de courant J (A/cm²). Les courbes A₁ et A₂ correspondent respectivement aux deux liaisons du tube 10.

Par ailleurs, avec les contacts de mesure 15 on repère la valeur de la densité de courant critique, c est-à-dire la valeur pour laquelle le champ électrique entre les deux contacts 15 devient non nul et égal à 1µV/cm.

Dans la figure 4, la droite B repère la valeur de la densité de courant critique et la droite C repère la valeur de la densité de courant pour laquelle on observe une chute ohmique de 10µV/cm.

Dans tout ce domaine de densités, la valeur de la résistivité ρₛ est sensiblement constante et reste inférieure à 7.10⁻¹² Ω.m².

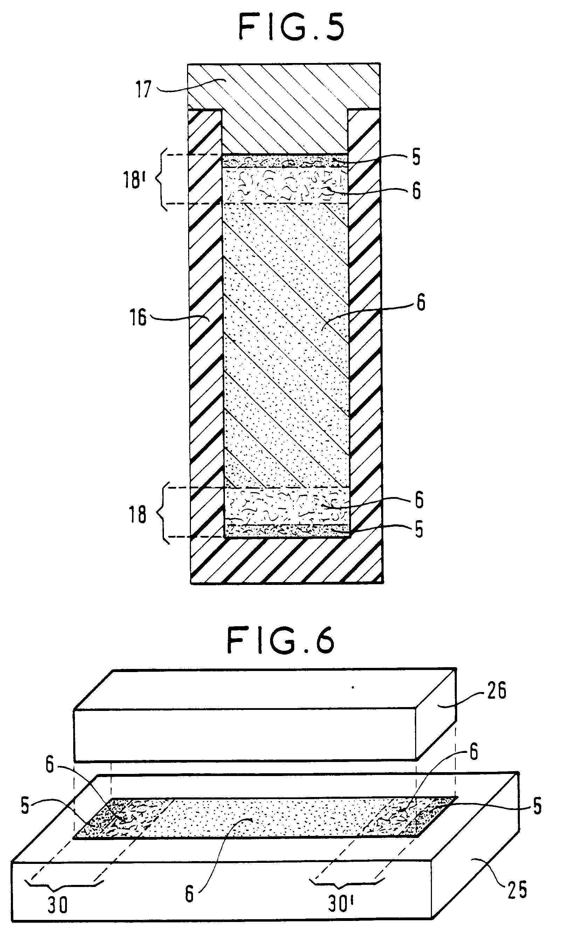

### EXEMPLE 2 (voir figure 5)

On opère de la même manière que dans l'exemple 1, mais avec un moule 16 de diamètre intérieur 7mm, fermé par un bouchon 17, sans broche métallique interne.

On cherche à réaliser un cyclindre plein de diamètre 5mm et de longueur 150mm.

On introduit donc successivement dans ce moule :
- un cylindre 18 en mousse d'argent de diamètre 7mm et de hauteur 15mn
- 0,5g de poudre d'argent 5
- 15g de granulés 6 de précurseurs
- un cylindre 18' en mousse d'argent analogue à l'anneau 18
- 0,5g de poudre d'argent 5.

Après une compression isostatique et un traitement thermique identiques à ceux de l'exemple 1, les mesures de résistivité des liaisons métalliques obtenues conduisent à des résultats sensiblement identiques à ceux de l'exemple 1.

### EXEMPLE 3 (voir figure 6)

On réalise de la manière suivante une pièce parallélépipédique de dimensions : 8 x 1,6 x 40mm³.
Dans une matrice en acier 25 associée à un poinçon en acier 26 pour compression uniaxiale, on dispose à chaque extrémité des parallélépipèdes 30 et 30' en mousse d'argent du type de celle de la figure 2.

On introduit ensuite dans les parties extrêmes de ces parallélépipèdes de la poudre d'argent. Enfin on remplit la matrice 25 et le reste des parallélépipèdes 30 et 30' avec des granulés 6 de précurseurs.

Après fermeture de la matrice avec le poinçon 26, on applique une force de 75.000 Newtons. Après démoulage et un traitement thermique dans les conditions déjà décrites, on retrouve au niveau des liaisons métallique les mêmes performances électriques que dans les exemples précédents.

### EXEMPLES 4- 5- 6

Ces exemples sont tout à fait analogues respectivement aux exemples 1, 2, 3 sauf en ce qui concerne la nature des granulés. En effet, on utilise dans les trois cas non pas un mélange stoechiométrique de précurseurs, mais une poudre déjà présynthétisée du composé Y₁Ba₂Cu₃O₇ référencée SU57 de la Société Rhone Poulenc.

On la mélange avec 10% en poids de poudre d'argent "pelliculaire", c'est-à-dire dont les grains sont des disques de diamètre compris entre 10 et 40 µm et d'épaisseur comprise entre 0,1 et 0,5 µm (référence HCF-38 de chez Heraeus).
La mise en forme est identique à celle qui a été décrite pour les exemples antérieurs ; toutefois, lors du traitement thermique la durée du palier entre 855°C et 880°C est réduite à 7 heures. On obtient alors un produit présentant un retrait de frittage plus homogène.

Bien entendu, l'invention n'est pas limitée aux modes de réalisation qui viennent d'être décrits. On pourra, sans sortir du cadre de l'invention, remplacer tout moyen par un moyen équivalent ; en particulier des structures poreuses de type paille ou toiles peut être utilisées à la place de la mousse métallique. L'argent peut être remplacé par l'or ou le cuivre.

## Revendications

1. Procédé de réalisation d'une liaison à hautes performances entre un métal et une pièce massive en céramique supraconductrice, ladite pièce étant fabriquée à partir de granulés, ou de poudre, de ladite céramique ou de ses précurseurs que l'on introduit dans un moule, procédé selon lequel, dans ledit moule, on juxtapose auxdits granulés, ou à ladite poudre de céramique au moins un volume de poudre d'argent ou d'or correspondant à la forme de ladite liaison et situé à l'endroit voulu, on comprime et on fritte la céramique, procédé caractérisé par le fait que l'on intègre dans ledit moule (1, 3, 3'), au niveau de ladite liaison, un corps (4, 4') en argent, or ou cuivre, à porosité ouverte, du genre mousse, paille, ou treillis, susceptible de contenir dans ses pores d'une part ledit volume (5) de poudre d'argent ou d'or, et d'autre par une fraction desdits granulés (6), ou de ladite poudre, de céramique.

2. Procédé selon la revendication 1, caractérisé par le fait que ledit corps et ladite poudre sont en argent.

3. Procédé selon l'une des revendications 1 et 2, caractérisé par le fait que le diamètre des pores du corps métallique est adapté à celui des granulés qui est compris entre 200µm et 1mm, et que sa porosité est supérieure à 85%.

4. Procédé selon l'une des revendications 1 à 3, caractérisé par le fait que, dans lesdits granulés, se trouve intégrée de la poudre d'argent pelliculaire dans une quantité inférieure à 15% en poids.

5. Pièce massive en céramique supraconductrice comportant une liaison métallique obtenue par le procédé selon l'une des revendications 1 à 4.

## Claims

1. Method of implementing a high-performance connection between a metal and a solid superconductive ceramic member, said member being fabricated from grains or powder of said ceramic or of its precursors that are introduced into a mold, in which method, in said mold, there is juxtaposed with said ceramic grains or powder at least one volume of silver powder or gold powder appropriate to the shape of said connection and situated at the required location, the ceramic is compressed and sintered, which method is characterized in that there is integrated into said mold (1, 3, 3'), at the level of said connection, a silver, gold or copper body (4, 4') of a porous nature, of the foam, straw or mesh type, adapted to contain within its pores said volume (5) of said silver or gold powder and some of said ceramic grains (6) or powder.

2. Method according to claim 1 characterized in that said body and said powder are silver.

3. Method according to claim 1 or claim 2 characterized in that the diameter of the pores of the metal body matches that of the grains which is between 200 µm and 1 mm and its porosity is greater than 85%.

4. Method according to any one of claims 1 to 3 characterized in that said grains integrate pellicular silver powder in an amount less than 15% by weight.

5. Solid superconductive ceramic member comprising a metal connection obtained by the method according to any one of claims 1 through 4.

## Patentansprüche

1. Verfahren zur Herstellung einer Hochleistungsverbindung zwischen einem Metall und einem massiven Teil aus supraleitender Keramik, wobei das Teil aus Granulat oder Pulver der betreffenden Keramik oder ihren Vorläufern herstellt wird, das man in eine Form einbringt, wobei man gemaß dem Verfahren in der Form dem Granulat oder dem Pulver aus Keramik mindestens ein Volumen Silber- oder Goldpulver entsprechend der Form der Verbindung und an der gewünschten Stelle anlagert und die Keramik verdichtet und sintert, dadurch gekennzeichnet, daß man in die Form (1, 3, 3') im Bereich der Verbindung einen Körper (4, 4') aus Silber oder aus Kupfer mit offener Porosität von einer Art eines Schwamms, Filzes oder Geflechts einbaut, der fähig ist, in seinen Poren einerseits das Volumen (5) des Silber- oder Goldpulvers und andererseits einen Teil des Granulats (6) oder des Pulvers aus Keramik zu enthalten.

2. Verfahren nach Anspruch 1, dadurch gekennzeichnet, daß der Körper und das Pulver aus Silber bestehen.

3. Verfahren nach Anspruch 1 oder 2, dadurch gekennzeichnet, daß der Durchmesser der Poren des Metallkörpers an den des Granulats angepaßt ist, der zwischen 200 µm und 1 mm liegt, und daß seine Porosität über 85% beträgt.

4. Verfahren nach einem der Ansprüche 1 bis 3, dadurch gekennzeichnet, daß in das Granulat plättchenförmiges Silberpulver in einer Menge kleiner als 15 Gew.% eingebunden ist.

5. Massives Teil aus supraleitender Keramik mit einer Metallverbindung, die durch das Verfahren gemäß einem der Ansprüche 1 bis 4 erhalten wird.
